# EUROPEAN PATENT APPLICATION

(11) **EP 3 567 640 A1**
(43) Date of publication of application: **13.11.2019**
(21) Application number: 18192921.7
(22) Date of filing: 06.09.2018
(51) Int. Cl.: H01L 31/049, H01L 31/048, E04B 2/88, B32B 17/10, B32B 17/00, H01L 31/0216, H02S 20/26

(54) **SOLAR CELL MODULE AND SOLAR PHOTOELECTRIC CURTAIN WALL**

(30) Priority: 08.05.2018 CN 201820677682 U; 08.05.2018 CN 201820677691 U
(71) Applicant: Beijing Hanergy Solar Power Investment Co., Ltd., 101499 Beijing (CN)
(72) Inventor: Wang, Chaoping, Beijing, 101499 (CN)
(74) Representative: Cohausz & Florack

(57) **Abstract**

The present disclosure provides a solar cell module. The solar cell module includes a solar cell chip (1). The solar cell chip (1) includes a back plate (11), and a cell functional layer (12) disposed on the back plate (11). The solar cell module further includes a protective substrate (3). The protective substrate (3) is disposed on the surface of the back plate (11) away from the cell functional layer (12). Further, a solar photoelectric curtain wall is provided.

## Description

This application claims benefit and priority to Chinese Patent Application No. 201820677682.3, filed on May 8, 2018, titled "A SOLAR CELL MODULE", and Chinese Patent Application No. 201820677691.2, filed on May 8, 2018, titled "A SOLAR CELL MODULE", which are incorporated herein by reference in their entirety.

### TECHNICAL FIELD

The present disclosure relates to, but not limited to, the technical field of building integrated photovoltaic, and in particular to, but not limited to, a solar cell module and a solar photoelectric curtain wall.

### BACKGROUND

A solar photovoltaic wall is a green decorative wall integrating the characteristic of a curtain wall and the power generation function. It can directly use sunlight to generate electricity, green, non-pollution, and without producing any greenhouse gases.

At present, a solar photoelectric curtain wall comprises a glass curtain wall and a solar cell chip bonded to the surface of the glass curtain wall by an adhesive sheet. Because the solar cell chip adopts an ordinary glass back plate, it is found that the solar photoelectric curtain wall has potential security risks in the process of testing the impact resistance of the solar photoelectric curtain wall when the solar cell chip is used in the solar photoelectric curtain wall.

### SUMMARY

The following is a summary of the subjects detailed in the present disclosure. This summary is not intended to limit the protection scope of the claims.

In one aspect, a solar cell module is provided. The solar cell module comprises a solar cell chip, the solar cell chip comprises a back plate, and a cell functional layer disposed on the back plate. The solar cell module further comprises a protective substrate, and the protective substrate is disposed on a surface of the back plate away from the cell functional layer.

In some embodiments of the present disclosure, the protective substrate comprises an explosion-proof unit. Alternatively, the explosion-proof unit is an explosion-proof film, a metal plate, a flexible film, or an elastic film; wherein the elastic modulus of the elastic film is greater than the elastic modulus of the flexible film.

In some embodiments of the present disclosure, the protective substrate comprises a back plate protection plate. The strength of the back plate protection plate is higher than the strength of the back plate.

In some embodiments of the present disclosure, the thickness of the back plate protection plate is larger than the thickness of the back plate.

In some embodiments of the present disclosure, the solar cell module further comprises a light-transmitting cover plate. The light-transmitting cover plate is disposed on a light-facing surface of the cell functional layer. Alternatively, a first adhesive film is disposed between the light-transmitting cover plate and the cell functional layer.

In some embodiments of the present disclosure, the thickness of the light-transmitting cover plate is larger than the thickness of the back plate.

In some embodiments of the present disclosure, the plate surface of the light-transmitting cover plate is provided with a decorative texture layer, wherein the plate surface of the light-transmitting cover plate is parallel to the light-facing surface of the cell functional layer.

In some embodiments of the present disclosure, the decorative texture layer comprises a decorative texture disposed on the plate surface of the light-transmitting cover plate.

In some embodiments of the present disclosure, the decorative texture layer comprises a texture film layer disposed on the plate surface of the light-transmitting cover plate.

In some embodiments of the present disclosure, the decorative texture layer is disposed on a surface of the light-transmitting cover plate away from the cell functional layer.

In some embodiments of the present disclosure, the light-transmitting cover plate is a colored cover plate.

In some embodiments of the present disclosure, at least one reflective coated layer or colored coated layer presenting an overall colored appearance is formed on the plate surface of the light-transmitting cover plate.

In some embodiments of the present disclosure, the light-transmitting cover plate is a single-layered colored cover plate.

In some embodiments of the present disclosure, a colored light-transmitting adhesive film is disposed between the light-facing surface of the cell functional layer and the light-transmitting cover plate.

In some embodiments of the present disclosure, the solar cell module further comprises at least one hollow component disposed on the side of the protective substrate away from the solar cell chip. The hollow component comprises a first substrate and a second substrate which are oppositely disposed. An air chamber for accommodating air is formed between the first substrate and the second substrate.

In some embodiments of the present disclosure, a second adhesive film is disposed between the back plate and the cell functional layer.

In another aspect, a solar photoelectric curtain wall comprising any of the solar cell modules described above is provided.

Other aspects will be apparent upon reading and understanding the accompanying drawings and the detailed description.

### BRIEF DESCRIPTION OF THE DRAWINGS

Figure 1 is a schematic structural diagram of a solar cell chip provided by some embodiments of the present disclosure.
Figure 2 is a schematic structural diagram 1 of a solar cell module provided by some embodiments of the present disclosure.
Figure 3 is a schematic structural diagram 2 of another solar cell module provided by some embodiments of the present disclosure.
Figure 4 is a schematic structural diagram 3 of a solar cell module provided by some embodiments of the present disclosure.
Figure 5 is a schematic structural diagram 4 of a solar cell module provided by some embodiments of the present disclosure.
Figure 6 is a schematic structural diagram 5 of a solar cell module provided by some embodiments of the present disclosure.
Figure 7 is a schematic structural diagram 6 of a solar cell module provided by some embodiments of the present disclosure.
Figure 8 is a schematic structural diagram 7 of a solar cell module provided by some embodiments of the present disclosure.
Figure 9 is a schematic structural diagram 8 of a solar cell module provided by some embodiments of the present disclosure.

### DETAILED DESCRIPTION

The technical solutions in the embodiments of the present disclosure will be described clearly and completely below with reference to the accompanying drawings in the embodiments of the present disclosure. Obviously, the described embodiments are merely some but not all embodiments of the present disclosure. All other embodiments obtained by the ordinarily skilled in the art based on the embodiments of the present disclosure without paying any creative effort shall be included in the protection scope of the present disclosure.

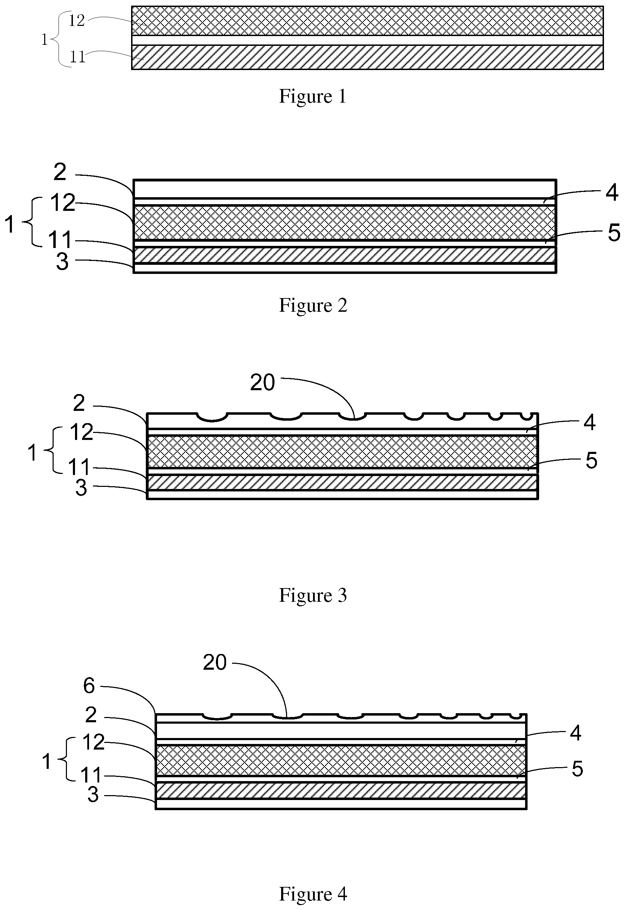

A solar photoelectric curtain wall provided by some exemplary embodiments of the present disclosure comprises a glass curtain wall, and a solar cell chip 1 as shown in Figure 1, the solar cell chip 1 is bonded to the surface of the glass curtain wall by an adhesive sheet. The solar cell chip 1 comprises a back plate 11, and a cell functional layer 12 disposed on the back plate 11.

The cell functional layer 12 is mainly composed of semiconductor devices, and is capable of receiving sunlight and performing photoelectric conversion. In some exemplary embodiments of the present disclosure, the surface on the side of the cell functional layer 12 for receiving sunlight is referred to as light-facing surface of the cell functional layer 12.

The above-mentioned back plate 11 may be a transparent or lightproof glass back plate. In this case, when the solar cell chip 1 constructed by such glass back plate is applied to a solar photoelectric curtain wall, it is easy for the glass back plate to fragment in the impact resistance test for the solar photoelectric curtain wall.

Further, the above-mentioned adhesive sheet for attaching the solar cell chip 1 to the glass curtain wall is inferior in bonding performance. Therefore, after the glass back plate of the solar cell chip 1 is broken, the fragments of the glass back plate falls easily, and thereby the solar photoelectric curtain wall has a safety hazard.

In order to solve the above problems, some embodiments of the present disclosure provide a solar cell module. The solar cell module includes the above-described solar cell chip 1 as shown in Figure 1, and further includes a protective substrate 3 as shown in Figure 2. The protective substrate 3 is disposed on the surface which is on the side of the back plate 11 away from the cell functional layer 12.

It should be noted that, in some embodiments of the present disclosure, the above-described cell functional layer 12 may be formed on the plate surface of the back plate 11 by a deposition process.

The plate surface of the above-described back plate 11 is parallel to the light-facing surface of the cell functional layer 12.

Alternatively, in some embodiments of the present disclosure, as shown in Figure 2, a second adhesive film 5 may be disposed between the cell functional layer 12 and the back plate 11, such that the cell functional layer 12 and the back plate 11 are bonded together via the second adhesive film 5, to further ensure the connection strength between the cell functional layer 12 and the back plate 11.

In addition, in order to protect the cell functional layer 12 from the effects of water, oxygen or impurities in the external environment on the interior of cell functional layer 12, as shown in Figure 2, the above-mentioned solar cell module further comprises a light-transmitting cover plate 2, which is disposed on the light-facing surface of the cell functional layer 12. As shown in Figure 2, a first adhesive film 4 may be provided between the above-mentioned light-transmitting cover plate 2 and the light-facing surface of the cell functional layer 12; so that the light-transmitting cover plate 2 and the cell functional layer 12 are bonded to each other via the first adhesive film 4. The first adhesive film 4 is a light-transmitting adhesive film.

It should be noted that, in some embodiments of the present disclosure, the above-mentioned light-transmitting cover plate 2 may be referred to as a light-transmitting front plate or a front plate protection plate, and needs to meet the light transmission characteristics.

From the above, it can be seen that the protective substrate 3 is disposed on the surface which is on the side of the back plate 11 away from the cell functional layer 12, so that when the solar cell module is impacted, on the one hand, the protective substrate 3 may be used to protect the back plate 11 to reduce the broken probability of the back plate 11; and on the other hand, if the impact force is too large and causes the broken of the back plate 11, the protective substrate 3 may also be used to restrain the fragments of the back plate.

Exemplarily, when the solar cell module is applied to a building based on Building Integrated Photo Voltaic (BIPV) such as a solar photoelectric curtain wall, the protective substrate 3 can not only reduce the broken probability of the back plate 11, but also restrain the fragments of the back plate 11 effectively in the case that the back plate 11 is broken, reducing the risk of the back plate fragments falling down to avoid unsafe accidents.

The above-mentioned unsafe accidents may be that: the fragments of the back plate 11 fall down, causing a pedestrian injury; or the back plate 11 is broken or has cracks, resulting in air entering the cell functional layer 12, causing the cell function layer to be prone to get heat and cause a fire in the power generation state.

In addition, the light-transmitting cover plate 2 is adhered to the light-facing surface of the cell functional layer 12, thus the cell functional layer can be protected by the light-transmitting cover plate 2.

On this basis, in some embodiments of the present disclosure, the above-mentioned light-transmitting cover plate 2 may use a substrate with a relatively high strength such as tempered glass, to further protect the solar cell chip 1. Besides, the light-transmitting front plate 2 may also use a substrate made of polymer material such as resin or the like, so as to further protect the solar cell chip 1. Of course, the light-transmitting front plate 2 may also use a light-transmitting elastic substrate, to cushion the received impact force, thereby weakening the impact force on the back plate 11.

The structure of the above-mentioned solar cell module will be exemplified below in accordance with different arrangements of the protective substrate 3.

### Example 1

The above-mentioned protective substrate 3 comprises an explosion-proof unit.

In some embodiments of the present disclosure, the protective substrates 3 may be classified into light-transmitting protective substrates 3 and lightproof protective substrates 3, according to whether the protective substrates can transmit a light, as long as it can play an explosion-proof effect. While according to different materials, in some embodiments of the present disclosure, the protective substrate 3 is an explosion-proof film, a metal plate, a flexible film or an elastic film.

The elastic modulus of the above-mentioned elastic film is larger than the elastic modulus of the flexible film. Further, the softness of the material of the flexible film is greater than the softness of the material of the elastic film.

Exemplarily, when the protective substrate 3 is an explosion-proof film, the explosion-proof film as the protective substrate 3 is relatively easy to purchase since it has been commercialized.

Alternatively, when the protective substrate 3 is a metal plate, because of its high strength, the metal plate can protect and support the back plate 11, and can carry the fragments of the back plate as the back plate is broken, to achieve the purpose of avoiding unsafe accidents.

Alternatively, when the protective substrate 3 is a flexible film, due to the good flexibility, the flexible film can be used to absorb the impact force acting on the back plate 11 as the solar cell module is impacted strongly, thereby further reducing the broken possibility of the back plate. Meanwhile, after the back plate is broken, because of the good flexibility, it is not easy that the fragments scratch the flexible film although the back plate fragments contact with the flexible film. In this way, the purpose of restraining the back plate fragments to avoid unsafe accidents is achieved.

Alternatively, when the protective substrate 3 is an elastic film, due to the good elasticity, the elastic film can be used to absorb the impact force acting on the back plate 11 as the solar cell module is impacted strongly, and quickly restore to the initial state, so as to support and protect the back plate 11, thereby further reducing the broken possibility of the back plate 11. Meanwhile, after the back plate 11 is broken, even if the back plate fragments contact with the elastic film, due to the good elastic deformation ability of the elastic film, the force applied to the elastic film by back plate fragments may be converted to the retracting force of the elastic film, thereby avoiding the elastic film to be scratched by the back plate fragments, and achieving the purpose of restraining the back plate fragments and avoiding unsafe accidents.In addition, in order to have a certain decorative effect on the building based on Building Integrated Photo Voltaic such as a glass curtain wall, which the solar cell module provided by some embodiments of the present disclosure is applied to,, a decorative texture layer having decorative effects may be added into the solar cell module The texture of the above-mentioned decorative texture layer may be a stone texture, a wood fiber texture, an imitation brick texture or the like, such that the above-mentioned solar cell module may be derived series components with a stone pattern, a wood pattern or a brick-like pattern.

In some embodiments of the present disclosure, the texture mentioned above may be a decorative pit texture.

In this case, in some embodiments of the present disclosure, the plate surface of the light-transmitting cover plate 2 is formed with a decorative texture layer. The decorative texture layer not only have the above decorative effect, but also can scatter the sunlight to reduce the light brightness reflected by the solar cell module, which is used in a building based on Building Integrated Photo Voltaic, thereby alleviating the glare problem.

In a specific implementation, the solar cell module provided by some embodiments of the present disclosure may allow the decorative texture layer to be disposed on the surface of the building based on Building Integrated Photo Voltaic in the following two manners.

The first manner: as shown in Figure 3, in some embodiments of the present disclosure, the decorative texture layer is a decorative pattern 20 disposed on the plate surface of the light-transmitting cover plate 2 by an etch process. By etching the decorative pattern 20 on the surface of the above-mentioned light-transmitting cover plate 2, the weight of the solar cell module may be reduced, so that the solar cell module may more easily meet the light-weighting requirements of a building based on Building Integrated Photo Voltaic.

The plate surface of the above-mentioned light-transmitting cover plate 2 is parallel to the light-facing surface of the cell functional layer 12.

The second manner: as shown in Figure 4, in some embodiments of the present disclosure, the decorative texture layer is a texture film layer 6 disposed on the plate surface of the above-mentioned light-transmitting cover plate 2. The texture film layer 6 may be a texture adhesive film, an ordinary texture film or a coated layer. The texture on the texture film layer 6 may be provided throughout or not throughout the texture film layer 6, or may be a pattern disposed on the texture film layer 6. In this case, by providing the texture film layer 6 on the plate surface of the above-mentioned light-transmitting front plate 2, when the solar cell module is applied to a building based on Building Integrated Photo Voltaic, the solar cell module can not only perform photovoltaic power generation, but also serve as decorative materials on the building based on Building Integrated Photo Voltaic.

Further, as shown in Figures 3 and 4, in some embodiments of the present disclosure, considering the decorative texture layer may realize the purpose of preventing glare, the decorative texture layer is disposed on the surface of the light-transmitting cover plate 2 away from the cell functional layer 12 in some embodiments of the present disclosure.

Exemplarily, in order to diversify the appearance of a building based on Building Integrated Photo Voltaic when the solar cell module provided by some embodiments of the present disclosure is applied to the building based on Building Integrated Photo Voltaic such as a glass curtain wall, the solar cell module provided by some embodiments of the present disclosure may realize the diversification of appearance color of the building based on Building Integrated Photo Voltaic in the following three manners. In this case, the solar cell module may be a colored drived series component, or a colored derived series component of a light-transmitting glass plate.

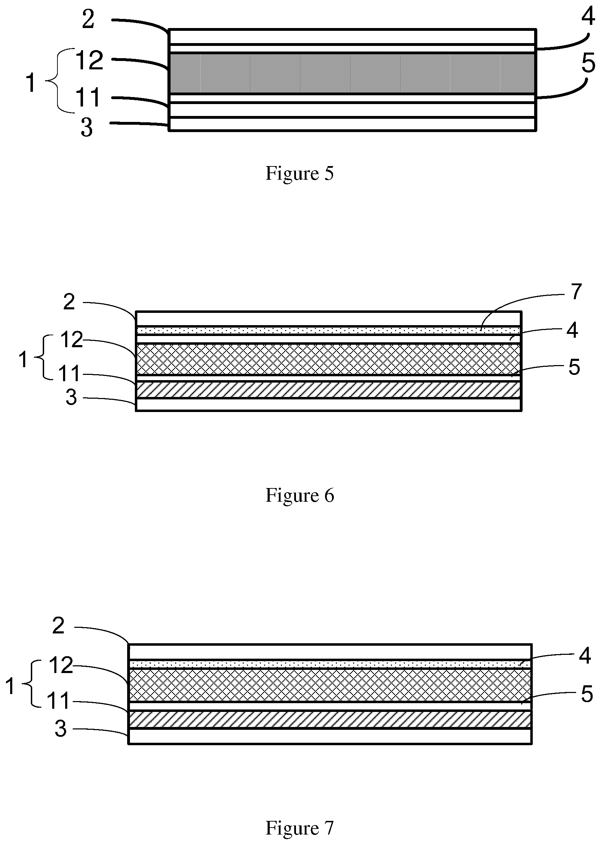

The first manner: as shown in Figure 5, the light-transmitting cover plate 2 is a colored cover plate, that is, the material of the light-transmitting cover plate 2 is colored glass or colored polymer material, so as to realize the diversification of outward appearance color of a building based on Building Integrated Photo Voltaic.

It should be noted that, in some embodiments of the present disclosure, the colored cover plate may be referred to as a colored front plate when the light-transmitting cover plate 2 is a light-transmitting front plate. Alternatively, the aforesaid colored cover plate may be referred to as a colored front plate protection plate when the light-transmitting cover plate 2 is a front plate protection plate.

The second manner: as shown in Figure 6, the plate surface of the light-transmitting cover plate 2 is formed with a colored film layer 7 to diversify the outward appearance color of a building based on Building Integrated Photo Voltaic. The colored film layer 7 may be at least one reflective coated layer or colored coated layer which presents an overall colored appearance. The reflective coated layer covers the light-transmitting cover plate 2 and can present various colors. The sunlight irradiates the reflective coated layer and is reflected, so that the light-transmitting cover plate 2 presents a colored visual effect. The reflective coated layer may be coated on the light-transmitting cover plate 2 by a method such as electroplating or magnetron sputtering. The material of the reflective coated layer (for example, titanium) may be set according to requirements, as long as it may achieve a colored visual effect of the light-transmitting cover plate 2. The colored coated layer may be adhered to the light-transmitting cover plate 2 by adhesive, and the colored coated layer, due to its own color, can make the light-transmitting cover plate 2 present colored appearance. The material of the colored coated layer (for example, a colored plastic film) may also be set according to requirements, as long as it may achieve a colored visual effect of the light-transmitting cover plate 2. As for this manner, the colored film layer 7 is exposed in the outside for a long period of time, which is prone to undesirable problems such as fading. Therefore, in this manner, the colored film layer 7 is formed on the surface of the light-transmitting cover plate 2 close to the cell functional layer 12 to protect the colored film layer 7, and to prevent the colored film layer 7 from being exposed in the air.

The third manner: as shown in Figure 7, in some embodiments of the present disclosure, when the light-transmitting cover plate 2 and the light-facing surface of the cell functional layer 12 are adhered together via a first adhesive film 4, the first adhesive film 4 may be defined as a colored light-transmitting adhesive film, so that the first film 4 can diversify the appearance color of a building based on Building Integrated Photo Voltaic while adhering the light-transmitting front plate 2 and the light-facing surface of the cell functional layer 12.

The solar cell module obtained based on the above three manners is applied to a building based on Building Integrated Photo Voltaic such as a glass curtain wall, not only making the building based on Building Integrated Photo Voltaic have a beautiful appearance, but also, compared with a conventional building based on Building Integrated Photo Voltaic, reducing the brightness of sunlight because of the low light transmittance of the colored cover plate, the colored film layer 7 or the colored light-transmitting adhesive film, thereby further protecting the cell functional layer 12 to avoid the service life loss of the cell functional layer 12 caused by excessive light.

In addition, in order to enable the solar cell module provided by some embodiments of the present disclosure to have effects of sound insulation, heat preservation, heat insulation and the like, when the solar cell module is applied to a building based on Building Integrated Photo Voltaic such as a glass curtain wall, so as to increase the occupancy experience of the residents in the building, the solar cell module described above may also be a hollow, soundproof and heatproof derived component.,

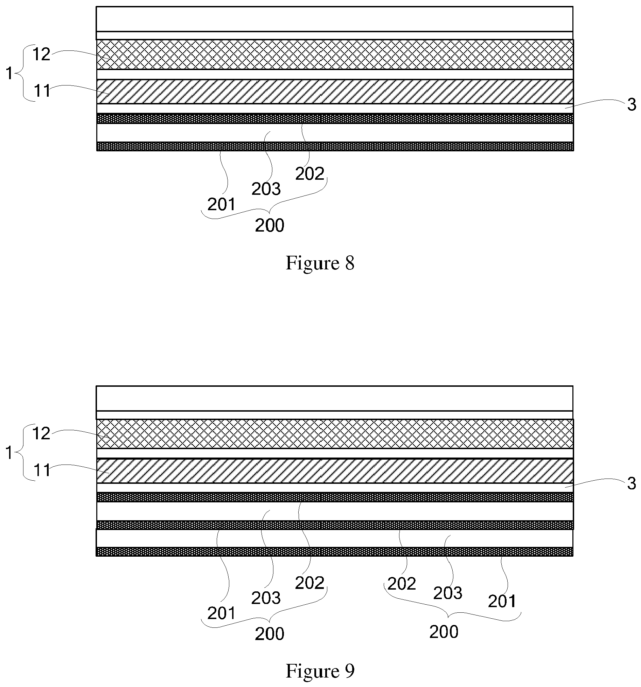

As shown in Figure 8, the above-mentioned solar cell module further includes a hollow component 200 disposed on a side of the protective substrate 3 away from the solar cell chip 1.

The hollow component 200 includes a first substrate 201 and a second substrate 202 disposed oppositely. An air chamber 203 for accommodating air is formed between the first substrate 201 and the second substrate 202.

The material of the first substrate 201 and the second substrate 202 is not limited in the present disclosure, and may be a polymer material or a glass. When the first substrate 201 and the second substrate 202 are made of glass, the hollow component 200 is a hollow glass. In this way, via the air chamber 203, the hot air and cold air from outside may be mixed, and the loss of the hot air or cold air in the room may be reduced to achieve the effect of heat preservation. Further, the above mentioned air chamber 203 may also absorb external noise to achieve the purpose of noise reduction.

It should be noted that, in some embodiments of the present disclosure, the solar cell module may include at least two hollow components 200 described above, and a plurality of hollow components 200 are stacked to improve the effect of sound insulation and heat insulation.

When a plurality of hollow components 200 are stacked, the air chambers 203 of two adjacent hollow components 200 may share one substrate. For example, as shown in Figure 9, when the solar cell module has two hollow components 200, the first substrate 201 in the upper hollow component 200 is also used as the second substrate 202 of the lower hollow component 200. The stacking manners of the rest hollow components 200 are as described above, and will not be further described herein.

In the description of the above embodiments, specific features, structures, materials or characteristics may be combined in any suitable manner in any one or more embodiments or examples.

According to a different arrangement of the protective substrate 3, another example of the structure of the above solar cell module is as follows:

### Example 2

The protective substrate 3 described above includes a back plate protection plate.

In some embodiments of the present disclosure, the protection for the back plate 11 by the light-transmitting cover plate 2 and the protective substrate 3 may be implemented in the following manners.

The first manner: the material kind of the protective substrate 3, the light-transmitting cover plate 2 and the back plate 11 may be limited, so that the strength of the protective substrate 3 and the strength of the light-transmitting cover plate 2 are greater than the strength of the back plate 11, to achieve the purpose of protecting the back plate 11 by the protective substrate 3 and the light-transmitting cover plate 2.

For example, the back plate 11 is generally an ordinary glass. In some embodiments of the present disclosure, tempered glass may be chosen as the protective substrate 3 and the light-transmitting cover plate 2, such that the strength of the protective substrate 3 and the strength of the light-transmitting cover plate 2 are greater than the strength of the back plate 11.

In addition, both the protective substrate 3 and the light-transmitting cover 2 are elastic substrates. The elastic substrate may cushion the impact force received by the solar cell module due to the elastic property, such that the strength of the protective substrate 3 and the strength of the light-transmitting cover plate 2 are greater than the strength of the back plate 11. At this time, the protective substrate 3 and the light-transmitting cover plate 2 may utilize the elasticity to cushion the impact force, to achieve the purpose of protecting the back plate 11. It should be noted here that at least the elastic substrate acting as the light-transmitting cover plate 2 needs to be transparent or light-transmitting to ensure that the sunlight can pass through the light-transmitting cover plate 2 to irradiate the cell functional layer 12. The light-transmitting elastic substrate is a light-transmitting elastic substrate made of a polyurethane material or a light-transmitting elastic substrate made of an ethylene acrylic acid copolymer.

Considering that when the strength of the light-transmitting cover plate 2 is inconsistent with that of the protective substrate 3, the protective capacity for the back plate 11 by the protective substrate 3 is inconsistent with the protection capacity for the back plate 11 by the light-transmitting cover plate 2 , which can easily cause the back plate 11 to suffer uneven force and then to be damaged, based on this, the protective substrate 3 and the light-transmitting cover plate 2 are of the same strength in some embodiments of the present disclosure. For example, when both the protective substrate 3 and the transparent cover 2 are a tempered glass, it is preferable to control the thickness of the protective substrate 3 to be consistent with the thickness of the light-transmitting cover plate 2. When both the protective substrate 3 and the transparent cover 2 are an elastic substrate, it should be ensured that the thicknesses of the protective substrate 3 and the light-transmitting cover plate 2 are the same on the basis of using the same elastic material.

The second manner: the types of the protective substrate 3, the light-transmitting cover plate 2 and the back plate 11 may be limited to be same, on this basis, the thicknesses of the protective substrate 3 and the light-transmitting cover plate 2 are larger than the thickness of the back plate 11, so that the protective substrate 3 and the light-transmitting cover plate 2 have a high strength. For example, when the front plate protection plate 3, the back plate protection plate 2 and the back plate 11 are all ordinary glasses, the thicknesses of the protective substrate 3 and the light-transmitting cover plate 2 may be limited to be larger than the thickness of the back plate 11.

When the protective substrate 3 includes the back plate protection plate, the solar cell module comprising the protective substrate 3 may be a lightproof colored derived series component, a lightproof derived series component with stone pattern, a light-transmitting derived component of a colored glass plate or a light-transmitting, hollow, soundproof and heatproof derived component, the arrangement manners of the above-mentioned derivative components are the same as described above, and will not be described hereto.

The above exemplary is only several specific embodiments of the present disclosure, and the protection extent of the present disclosure is not limited within these. Any variations and substitutions readily conceivable for those skilled in the art within some technical scopes disclosed in the present disclosure shall be within the protection scope of some of the present disclosure. Therefore, the scope of protection of the present disclosure shall be determined by the scope of the claims.

## Claims

1. A solar cell module comprising a solar cell chip (1), wherein the solar cell chip (1) comprises a back plate (11), and a cell functional layer (12) disposed on the back plate (11),
the solar cell module further comprises a protective substrate (3), the protective substrate (3) is disposed on a surface of the back plate (11) away from the cell functional layer (12).

2. The solar cell module according to claim 1, wherein, the protective substrate (3) comprises an explosion-proof unit;
the explosion-proof unit is an explosion-proof film, a metal plate, a flexible film, or an elastic film;
wherein, the elastic modulus of the elastic film is greater than the elastic modulus of the flexible film.

3. The solar cell module according to claim 1 or 2, wherein, the protective substrate (3) comprises a back plate protection plate, the strength of the back plate protection plate is greater than the strength of the back plate (11); optionally, the thickness of the back plate protection plate is larger than the thickness of the back plate (11).

4. The solar cell module according to any one of claims 1-3, wherein, the solar cell module further comprises a light-transmitting cover plate (2),
the light-transmitting cover plate (2) is provided on a light-facing surface of the cell functional layer (12),
a first adhesive film (4) is provided between the light-transmitting cover plate (2) and the cell functional layer (12).

5. The solar cell module according to claim 4, wherein, the thickness of the light-transmitting cover plate (2) is larger than the thickness of the back plate (11).

6. The solar cell module according to claim 4, wherein, the surface of the light-transmitting cover plate (2) is provided with a decorative texture layer,
wherein, the plate surface of the light-transmitting cover plate (2) is parallel to the light-facing surface of the cell functional layer (12).

7. The solar cell module according to claim 6, wherein, the decorative texture layer comprises a decorative pattern (20) disposed on the plate surface of the light-transmitting cover plate (2);
optionally, the decorative texture layer comprises a texture film layer (6) disposed on the plate surface of the light-transmitting cover plate (2).

8. The solar cell module according to claim 6, wherein, the decorative texture layer is disposed on a surface of the light-transmitting cover plate (2) away from the cell functional layer (12).

9. The solar cell module according to any one of claims 4-8, wherein, the light-transmitting cover plate (2) is a colored cover plate; or, the plate surface of the light-transmitting cover plate (2) is formed with a colored film layer (7).

10. The solar cell module according to claim 9, wherein, the light-transmitting cover plate (2) is provided on its plate surface with at least one reflective coated layer or colored coated layer which presents an overall colored appearance.

11. The solar cell module according to claim 9, wherein, the light-transmitting cover plate (2) is a single-layered colored cover plate.

12. The solar cell module according to any one of claims 4-8, wherein, a colored light-transmitting adhesive film is disposed between the light-facing surface of the cell functional layer (12) and the light-transmitting cover plate (2).

13. The solar cell module according to any one of claims 1-12, wherein, the solar cell module further comprises at least one hollow component (200) disposed on a surface of the protective substrate (3) away from the solar cell chip (1),
the hollow component (200) comprises a first substrate (201) and a second substrate (202) disposed oppositely, an air chamber (203) for filling air is formed between the first substrate (201) and the second substrate (202).

14. The solar cell module according to any one of claims 4-8, wherein, a second adhesive film (5) is disposed between the back plate (11) and the cell functional layer (12).

15. A solar photoelectric curtain wall comprising the solar cell module according to any one of claims 1-14.
